# EUROPÄISCHE PATENTSCHRIFT

(11) **EP 1 316 144 B1**
(45) Veröffentlichungstag und Bekanntmachung des Hinweises auf die Patenterteilung: **19.05.2004**
(21) Anmeldenummer: 01967070.2
(22) Anmeldetag: 06.09.2001
(51) Int. Cl.: H03D 3/00

(54) **EMPFÄNGERSCHALTUNG , INSBESONDERE FÜR DEN MOBILFUNK**
RECEIVER CIRCUIT, ESPECIALLY FOR MOBILE RADIOTELEPHONY
CIRCUIT DE RECEPTION DESTINE NOTAMMENT A LA TELEPHONIE MOBILE

(30) Priorität: 08.09.2000 DE 10044456
(43) Veröffentlichungstag der Anmeldung: 04.06.2003
(73) Patentinhaber: Infineon Technologies AG, 81669 München (DE)
(72) Erfinder: HAMMES, Markus, 46539 Dinslaken (DE); HEINEN, Stefan, D-52499 Baesweiler (DE); VAN WAASEN, Stefan, 47178 Duisburg (DE); HANKE, André, 40468 Düsseldorf (DE); WAGNER, Elmar, 47269 Duisburg (DE)
(74) Vertreter: Epping Hermann & Fischer
(86) Internationale Anmeldenummer: PCT/DE2001/003426
(87) Internationale Veröffentlichungsnummer: WO 2002/021681

(56) Entgegenhaltungen:
- WO-A-00/22735
- US-A- 5 734 683
- US-A- 5 764 171
- US-A- 5 828 955
- US-A- 6 005 506
- S. JANTZI: "QUADRATURE BANDPASS DELTA-SIGMA MODULATION FOR DIGITAL RADIO" IEEE JOURNAL OF SOLID STATE CIRCUITS, Bd. 32, Nr. 12, 1. Dezember 1997 (1997-12-01), Seiten 1935-1950, XP000767443 NEW YORK,US

## Beschreibung

Die vorliegende Erfindung betrifft eine Empfängerschaltung zur Demodulation eines Hochfrequenzsignals, insbesondere für den Mobilfunk.

Zum Empfang hochfrequenter, modulierter Signale werden in Mobilfunk-Anwendungen und Schnurlostelefonen normalerweise Superheterodyn-Empfangsarchitekturen eingesetzt. Diese weisen eine verhältnismäßig hohe Zwischenfrequenzebene auf. Die superheterodyne Architektur hat den Nachteil eines großen Flächenbedarfs und der verhältnismäßig schlechten Integrationsmöglichkeiten.

Zur Verbesserung der monolithischen Integration von Mobilfunkempfängern besteht ein Trend zu Funkempfängern mit geringer Zwischenfrequenz oder mit der Zwischenfrequenz Null.

Derartige Funkempfänger mit geringer Zwischenfrequenz können einen analogen Aufbau aufweisen. Zu integrierende, analoge Bauteile sind jedoch üblicherweise stark toleranzbehaftet, so daß eine erforderliche Empfindlichkeit des Empfängers nicht oder nur mit großem Aufwand erreichbar ist.

Weiterhin sind Empfängerarchitekturen bekannt, welche nach dem Empfänger-Frontend auf der Zwischenfrequenzebene Analog/Digital-Wandler einsetzen, um eine digitale Weiterverarbeitung der Empfangssignale zu ermöglichen. An diese Analog/Digital-Wandler werden hohe Anforderungen an Auflösung und Präzision gestellt, so daß diese einen großen Chipflächenbedarf sowie eine hohe Stromaufnahme aufweisen. Diese Nachteile stehen jedoch den im Mobilfunk allgemein geltenden Forderungen nach immer kleineren Abmessungen, geringerem Gewicht sowie längerer Batterielebensdauer der Mobilfunk-Geräte entgegen.

In dem Dokument "A Delta-Sigma PLL for 14-b, 50 kSample/s Frequency-to-Digital Conversion of a 10 MHz FM Signal", Ian Galton et al., IEEE JSSC, Vol. 33, Dec. 1998, S. 2042-2053, ist ein Funk-Empfänger angegeben, bei dem auf einer Zwischenfrequenzebene ein Filter mit nachgeschalteten Limiter, ΔΣ-Wandler und Decimation Filter vorgesehen ist. Diese Anordnung ersetzt die als aufwendig erachtete, analoge Quadratur-Abwärts-Konversion mit je einem AD-Wandler in Inphase- und Quadraturzweig.

Weitere, derartige Schaltungsanordnungen sind in den Dokumenten US 5,764,171 und US 6,055,506 angegeben. Das Dokument US 5,764,171 zeigt einen Quadratursignalkonverter, der eine Mischerstufe zur Ausgabe eines komplexwertigen Signals, ein Polyphasenfilter und einen Sigma-Delta-Modulator umfasst. In dem Dokument US 6,005,506 ist ein Empfänger mit Sigma-Delta Analog/Digital Konverter zur Abtastung eines empfangenen Signals angegeben, der eine Mischerstufe zur Ausgabe eines komplexwertigen Signals umfasst.

Aufgabe der vorliegenden Erfindung ist es daher, eine Empfängerschaltung (Receiver) zur Demodulation eines Hochfrequenzsignals anzugeben, welche eine hohe Empfindlichkeit, geringes Rauschen sowie geringen Chipflächenbedarf aufweist.

Erfindungsgemäß wird die Aufgabe mit einer Empfängerschaltung zur Demodulation eines Hochfrequenzsignals gelöst, mit
- einer Mischerstufe, der an einem ersten Eingang das zu demodulierende Hochfrequenzsignal zuführbar ist und an deren Ausgang ein vom Hochfrequenzsignal abgeleitetes Zwischenfrequenzsignal bereitsteht,
- einer begrenzenden Verstärkerstufe, der das Zwischenfrequenzsignal zuführbar ist und an deren Ausgang ein vom Zwischenfrequenzsignal abgeleitetes, wertdiskretes Signal vorliegt und
- einem Sigma-Delta-Wandler, der an den Ausgang der begrenzenden Verstärkerstufe angeschlossen ist, und
- einem Polyphasenfilter zur Kanalselektion, welches zwischen Mischerstufe und begrenzender Verstärkerstufe vorgesehen ist.

Der auf der Zwischenfrequenzebene vorgesehene, begrenzende Verstärker stellt an seinem Ausgang das vom Hochfrequenzsignal abgeleitete Zwischenfrequenzsignal wertdiskret und zeitkontinuierlich zur Verfügung. Der begrenzende Verstärker ordnet dem Signal logische Zustände, beispielsweise 0 (low) oder 1 (high) zu. Das Zwischenfrequenzsignal kann in seine Quadraturkomponenten zerlegt sein. An den Ausgang der begrenzenden Verstärkerstufe ist ein Sigma-Delta-Wandler angeschlossen, an dessen Ausgang ein digitales, zeit- und wertdiskretes Signal vorliegt, welches digital demodulierbar ist.

Der Sigma-Delta-Wandler kann eine Überabtastung (oversampling) des vom Zwischenfrequenzsignal abgeleiteten, wertdiskreten Signals aufweisen.

Die vorliegende Empfängerschaltung weist eine hohe Empfindlichkeit bei geringem Rauschen sowie bei geringem Chipflächenbedarf auf.

Gemäß vorliegendem Prinzip ist zwischen Mischerstufe und begrenzender Verstärkerstufe ein Kanalfilter zur Kanalselektion vorgesehen. Das Kanalfilter kann zum Unterdrücken unerwünschter Frequenzen dienen. Da das Zwischenfrequenzsignal als komplexes, in Inphase- und Quadraturkomponente zerlegtes Signal vorliegt, ist das Kanalfilter vorteilhafterweise als komplexes Filter, nämlich als Polyphasenfilter ausgebildet.

In einer vorteilhaften Weiterbildung der vorliegenden Erfindung ist ein digitaler Demodulator vorgesehen, der an einen Ausgang des Sigma-Delta-Wandlers angeschlossen ist. Da am Ausgang des Sigma-Delta-Wandlers bereits digitale, zeit- und wertdiskrete Signale vorliegen, ist in einfacher Weise und mit geringem Aufwand unmittelbar eine digital Demodulation möglich.

In einer weiteren, vorteilhaften Ausführungsform der vorliegenden Erfindung ist ausgangsseitig am Sigma-Delta-Wandler ein Dezimationsglied vorgesehen. Das Dezimationsglied kann die Taktrate des ausgangsseitig am Sigma-Delta-Wandler ableitbaren Signals reduzieren, wodurch sich die Möglichkeit einer Weiterverarbeitung, beispielsweise Demodulation, des Signals mit geringem Aufwand ergibt. Weiterhin kann die durch die Überabtastung des Sigma-Delta-Wandlers bedingte, hohe Taktrate reduziert werden.

In einer weiteren, vorteilhaften Ausführungsform der vorliegenden Erfindung ist der Sigma-Delta-Wandler ein zeitkontinuierlicher Bandpass-Sigma-Delta-Modulator. Aufgrund der Bandpass-Eigenschaften des Sigma-Delta-Wandlers werden höhere Harmonische des Zwischenfrequenz-Signals herausgefiltert.

In einer weiteren, vorteilhaften Ausführungsform der vorliegenden Erfindung ist im Sigma-Delta-Wandler ein Polyphasenfilter vorgesehen. Somit ist im komplexen Frequenzspektrum ein Herausfiltern unerwünschter Signalanteile möglich.

Die Empfängerschaltung kann für geringe Zwischenfrequenzen (low IF) ausgelegt sein. Beispielsweise können die Zwischenfrequenzsignal-Frequenzen kleiner oder gleich 20 MHz betragen.

Zur Zuführung des Hochfrequenzsignals kann die Mischerstufe mit ihrem ersten Eingang an eine Antenne angeschlossen sein.

An einem zweiten Eingang der Mischerstufe kann ein komplexes Trägersignal zuführbar sein. Die Frequenz des komplexen Trägersignals, welches in I- und Q-Komponenten zerlegt ist, kann jeweils derart anpaßbar sein, daß am Ausgang der Mischerstufe stets ein Zwischenfrequenzsignal mit fester Trägerfrequenz vorliegt.

Weitere Einzelheiten der Erfindung sind in den Unteransprüchen angegeben.

Die Erfindung wird nachfolgend an einem Ausführungsbeispiel anhand der Zeichnungen näher erläutert.

Es zeigt:

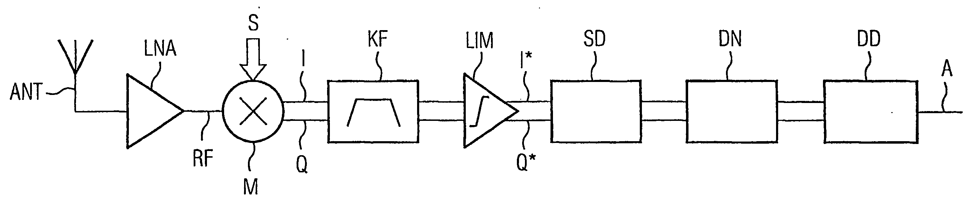

Die Figur eine beispielhafte Ausführungsform der Empfängerschaltung anhand eines vereinfachten Blockschaltbildes.

Die Figur zeigt eine Mischerstufe M, der an einem ersten Eingang ein zu demodulierendes Hochfrequenzsignal RF und an einem zweiten Eingang ein komplexes Trägersignal S zuführbar ist. Die Mischerstufe kann zwei analog aufgebaute Mischer aufweisen, von denen einer das Trägersignal unverändert und der anderen das Trägersignal um 90° phasenverschoben zuführbar ist. An den ersten Eingang der Mischerstufe ist eine Antenne ANT mit nachgeschaltetem, rauscharmem Vorverstärker LNA angeschlossen.

Am Ausgang der Mischerstufe, auf der Zwischenfrequenzebene, ist ein vom Hochfrequenzsignal RF abgeleitetes Zwischenfrequenzsignal I, Q mit Inphase-Komponente I und Quadratur-Komponente Q vorhanden. Insbesondere zur Filterung unerwünschter Signale ist dem Mischer M ein Kanalfilter KF, welches als Polyphasenfilter ausgebildet ist, nachgeschaltet. An dieses ist ausgangsseitig eine begrenzende Verstärkerstufe LIM angeschlossen, der das komplexe Zwischenfrequenzsignal I, Q zuführbar ist und an deren Ausgang ein vom Zwischenfrequenzsignal abgeleitetes, wertdiskretes Signal I*, Q* zur Verfügung steht. Das wertdiskrete Signal kann beispielsweise jeweils den Zustand 0 (low) oder high (1) aufweisen. Das ausgangsseitig am begrenzenden Verstärker LIM ableitbare Signal ist ein zeitkontinuierliches Signal.

Am Ausgang des begrenzenden Verstärkers LIM ist ein Sigma-Delta-Modulator, welcher als zeitkontinuierlicher Sigma-Delta-Bandpass-Wandler ausgeführt ist, angeschlossen. Der Sigma-Delta-Wandler SD hat zum einen die Funktion, das an seinem Eingang anliegende, wertdiskrete, zeitkontinuierliche Signal in ein wert- und zeitdiskretes Signal zu konvertieren und zum anderen durch die integrierte Bandpass-Funktion unerwünschte, höhere harmonische des wertdiskreten Signals I*, Q* herauszufiltern.

Aufgrund der Überabtastung des Sigma-Delta-Wandlers wird das Quantisierungsrauschen deutlich reduziert.

An den Sigma-Delta-Wandler ist ausgangsseitig ein Dezimationsglied DN sowie ein digitaler Demodulator DD angeschlossen, an dessen Ausgang das demodulierte, digitale Signal A zur Verfügung steht.

Das Dezimationsglied DN dient zur Reduzierung der Taktrate des am Sigma-Delta-Wandler ausgangsseitig ableitbaren, digitalen Signals, dessen Taktrate insbesondere aufgrund der Überabtastung hoch ist.

Die Zwischenfrequenzebene der vorliegenden Empfängeranordnung ist für geringe Zwischenfrequenzen (Low IF, low intermediate frequency) ausgelegt. Zur einfacheren, digitalen Weiterverarbeitung kann das komplexe digitale Ausgangssignal des Sigma-Delta-Wandlers mittels eines komplexen Mischers auf die Trägerfrequenz Null heruntergemischt werden.

Die beschriebene Empfängerschaltung gemäß der Figur weist eine hohe Genauigkeit, einen geringen Flächenbedarf, sowie geringen Strombedarf auf. Zudem ergibt sich eine weitgehende Unabhängigkeit der bei Analogbauelementen üblicherweise auftretenden, fertigungsbedingten Toleranzen.

## Patentansprüche

1. Empfängerschaltung zur Demodulation eines Hochfrequenzsignals (RF) mit
- einer Mischerstufe (M), der an einem ersten Eingang das zu demodulierende Hochfrequenzsignal (RF) zuführbar ist und an deren Ausgang ein vom Hochfrequenzsignal (RF) abgeleitetes, komplexwertiges Zwischenfrequenzsignal (I,Q) bereitsteht,
- einer begrenzenden Verstärkerstufe (LIM), der das Zwischenfrequenzsignal zuführbar ist und an deren Ausgang ein vom Zwischenfrequenzsignal (I,Q) abgeleitetes, wertdiskretes, komplexwertiges Signal (I*,Q*) vorliegt,
- einem Sigma-Delta-Wandler (SD), der an den Ausgang der begrenzenden Verstärkerstufe (LIM) angeschlossen ist, und
- einem Polyphasenfilter (KF) zur Kanalselektion, welches zwischen Mischerstufe (M) und begrenzender Verstärkerstufe (LIM) vorgesehen ist.

2. Empfängerschaltung nach Anspruch 1,
**dadurch gekennzeichnet,**
**daß** ein digitaler Demodulator (DD) vorgesehen ist, der an einen Ausgang des Sigma-Delta-Wandlers (SD) angeschlossen ist.

3. Empfängerschaltung nach Anspruch 1 oder 2,
**dadurch gekennzeichnet,**
**daß** ein Dezimationsglied (DN) ausgangsseitig am Sigma-Delta-Wandler (SD) vorgesehen ist.

4. Empfängerschaltung nach einem der Ansprüche 1 bis 3
**dadurch gekennzeichnet,**
**daß** der Sigma-Delta-Wandler (SD) ein zeitkontinuierlicher Bandpass-Sigma-Delta-Modulator ist.

5. Empfängerschaltung nach einem der Ansprüche 1 bis 4,
**dadurch gekennzeichnet,**
**daß** im Sigma-Delta-Wandler (SD) ein Polyphasenfilter zum Filtern des komplexen Frequenzspektrums vorgesehen ist.

6. Empfängerschaltung nach einem der Ansprüche 1 bis 5,
**dadurch gekennzeichnet,**
**daß** die Frequenzebene des Zwischenfrequenzsignals (I,Q) kleiner oder gleich 20 MHz beträgt.

7. Empfängerschaltung nach einem der Ansprüche 1 bis 6,
**dadurch gekennzeichnet,**
**daß** der erste Eingang der Mischerstufe (M) an eine Antenne (ANT) angeschlossen ist.

8. Empfängerschaltung nach einem Ansprüche 1 bis 7,
**dadurch gekennzeichnet,**
**daß** einem zweiten Eingang der Mischerstufe (M) ein komplexes Trägersignal (S) zuführbar ist.

## Claims

1. Receiver circuit for demodulating a radio-frequency signal (RF), having
- a mixer stage (M) which can be fed at a first input the radio-frequency signal (RF) to be demodulated, and at whose output a complex-valued intermediate frequency signal (I, Q) derived from the radio-frequency signal (RF) is available,
- a limiting amplifier stage (LIM) which can be fed the intermediate-frequency signal, and at whose output a value-discrete, complex-valued signal (I*, Q*) derived from the intermediate-frequency signal (I, Q) is present,
- a sigma-delta converter (SD) which is connected to the output of the limiting amplifier stage (LIM), and
- a polyphase filter (KF) for channel selection which is provided between the mixer stage (M) and limiting amplifier stage (LIM).

2. Receiver circuit according to Claim 1, **characterized in that** a digital demodulator (DD) is provided which is connected to an output of the sigma-delta converter (SD).

3. Receiver circuit according to Claim 1 or 2, **characterized in that** a decimation element (DN) is provided on the output side at the sigma-delta converter (SD).

4. Receiver circuit according to one of Claims 1 to 3, **characterized in that** the sigma-delta converter (SD) is a time-continuous bandpass sigma-delta modulator.

5. Receiver circuit according to one of Claims 1 to 4, **characterized in that** a polyphase filter for filtering the complex frequency spectrum is provided in the sigma-delta converter (SD).

6. Receiver circuit according to one of Claims 1 to 5, **characterized in that** the frequency plane of the intermediate frequency signal (I, Q) is less than or equal to 20 MHz.

7. Receiver circuit according to one of Claims 1 to 6, **characterized in that** the first input of the mixer stage (M) is connected to an antenna (ANT).

8. Receiver circuit according to one of Claims 1 to 7, **characterized in that** a complex carrier signal (S) can be fed to a second input of the mixer stage (M).

## Revendications

1. Circuit récepteur pour la démodulation d'un signal à haute fréquence (RF), comportant
- un étage mélangeur (M) auquel le signal à haute fréquence (RF) à démoduler peut être envoyé sur une première entrée et à la sortie duquel un signal à fréquence intermédiaire à valeurs complexes (I, Q) déduit du signal à haute fréquence (RF) est disponible,
- un étage amplificateur limiteur (LIM) auquel le signal à fréquence intermédiaire peut être envoyé et à la sortie duquel un signal à valeurs complexes (I*, Q*) à valeurs discrètes déduit du signal à fréquence intermédiaire (I, Q) est disponible,
- un convertisseur Sigma-Delta (SD) qui est raccordé à la sortie de l'étage amplificateur limiteur (LIM), et
- un filtre polyphasé (KF) qui est destiné à la sélection de canal et qui est prévu entre l'étage mélangeur (M) et l'étage amplificateur limiteur (LIM).

2. Circuit récepteur selon la revendication 1, **caractérisé par le fait qu'**il est prévu un démodulateur numérique (DD) qui est raccordé à une sortie du convertisseur Sigma-Delta (SD).

3. Circuit récepteur selon la revendication 1 ou 2, **caractérisé par le fait qu'**un élément de décimation (DN) est prévu du côté de la sortie du convertisseur Sigma-Delta (SD).

4. Circuit récepteur selon l'une des revendications 1 à 3, **caractérisé par le fait que** le convertisseur Sigma-Delta (SD) est un modulateur Sigma-Delta passe-bande continu dans le temps.

5. Circuit récepteur selon l'une des revendications 1 à 4, **caractérisé par le fait qu'**un filtre polyphasé est prévu dans le convertisseur Sigma-Delta (SD) pour filtrer le spectre fréquentiel complexe.

6. Circuit récepteur selon l'une des revendications 1 à 5, **caractérisé par le fait que** le niveau de fréquence du signal à fréquence intermédiaire (I, Q) est inférieur ou égal à 20 MHz.

7. Circuit récepteur selon l'une des revendications 1 à 6, **caractérisé par le fait que** la première entrée de l'étage mélangeur (M) est raccordée à une antenne (ANT).

8. Circuit récepteur selon l'une des revendications 1 à 7, **caractérisé par le fait qu'**un signal porteur complexe (S) peut être envoyé à une deuxième entrée de l'étage mélangeur (M).
